# EUROPEAN PATENT APPLICATION

(11) **EP 4 745 589 A1**
(43) Date of publication of application: **20.05.2026**
(21) Application number: 25215680.7
(22) Date of filing: 13.11.2025
(51) Int. Cl.: G01R 31/317, G01R 31/3185, G06F 11/273

(54) **SYSTEM AND METHOD FOR TESTING IDENTICAL CORES**

(30) Priority: 18.11.2024 IN 202441088945
(71) Applicant: NXP B.V., 5656 AG Eindhoven (NL)
(72) Inventor: GOYAL, Tarun Kumar, 5656AG Eindhoven (NL); MAHAJAN, Abhishek, 5656AG Eindhoven (NL); DALAL, Dishank Paragkumar, 5656AG Eindhoven (NL)
(74) Representative: Hardingham, Christopher Mark

(57) **Abstract**

An integrated circuit, IC, and a diagnostic method for facilitating testing of identical cores is provided. The IC comprising a plurality of cores that are identical, wherein each core of the plurality of cores is configured to generate a respective test output based on a plurality of test patterns; and a diagnostic circuit coupled to the plurality of cores. The diagnostic circuit being configured to: (1) receive a plurality of test outputs that include the test output of each of the plurality of cores and a default selection signal, wherein the default selection signal indicates one of the plurality of test outputs as a default test output; (2) identify, based on the plurality of test outputs and the default test output, a defective set of cores of the plurality of cores; and (3) output a set of defective outputs associated with the defective set of defective cores as a set of failure logs.

## Description

### FIELD OF USE

The present disclosure relates generally to electronic circuits and, more particularly, to systems and methods for testing identical cores of integrated circuits.

### BACKGROUND

Modern integrated circuits (ICs) of electronic devices include a large number of processing cores to execute various operations of the ICs. Prior to being implemented in an electronic device, an IC is tested to validate a performance of the IC. However, due to the large number of processing cores in an IC, various challenges occur during the testing of the IC. As each processing core is typically associated with a number of configuration parameters such as an instruction set, memory access pattern, or the like, different test patterns are utilized thereby consuming extensive resources for testing the IC. In addition, testing each core consumes a large amount of time.

### BRIEF DESCRIPTION OF DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a schematic diagram of a testing environment in accordance with an embodiment of the present disclosure;
FIG. 2 illustrates a schematic block diagram of a diagnostic circuit of the testing environment of FIG. 1 in accordance with an embodiment of the present disclosure;
FIG. 3 illustrates a schematic block diagram of a comparator circuit of the diagnostic circuit of FIG. 2 in accordance with an embodiment of the present disclosure;
FIG. 4 illustrates a schematic block diagram of a selection circuit of the diagnostic circuit of FIG. 2 in accordance with an embodiment of the present disclosure; and
FIGS. 5A and 5B, collectively, represent a flowchart that illustrates a diagnostic method executed by an integrated circuit of the testing environment of FIG. 1 in accordance with an embodiment of the present disclosure.

### DETAILED DESCRIPTION

The detailed description of the appended drawings is intended as a description of the embodiments of the present disclosure and is not intended to represent the only form in which the present disclosure may be practiced. It is to be understood that the same or equivalent functions may be accomplished by different embodiments that are intended to be encompassed within the spirit and scope of the present disclosure.

### Overview:

Integrated circuits (ICs) include cores to execute various processing operations of an electronic device. Prior to being implemented in the electronic device, an IC is typically tested to identify any faults or errors in a performance of the IC. To reduce a testing time and resources utilized to test an IC, cores that have an identical design are tested simultaneously. The identical cores receive test patterns from a test system that is external to the IC. Upon receiving the test patterns, each core generates a corresponding test output. Each core is further linked with corresponding output terminals of the IC such that the test system receives the test output from each core by way of the corresponding output terminals. However, a large number of output terminals are typically included on ICs that have a large number of identical cores thereby increasing a size, design complexity, and manufacturing costs of such ICs.

Other known methods of testing the ICs include comparing the test outputs from each core with a reference test output to generate a status bit by a compare circuit of the IC. The generated status bits are provided to the test system by way of the output terminals of the IC. Based on the status bits, the test system determines whether at least one of the cores is defective. Upon determining that at least one of the cores is defective, the test system further generates new test patterns for receiving the test outputs of the one or more defective cores. The generation of the new test patterns causes a processing overhead on the test system and delays the testing of the IC. Therefore, there exists a need for a system and method that overcomes the aforementioned problems to test identical cores of an IC.

Various embodiments of the present disclosure disclose an IC that includes identical cores and a diagnostic circuit coupled to the identical cores. Each identical core may generate a test output based on test patterns. The diagnostic circuit may receive the test outputs from the identical cores and a default selection signal from a test system that may be external to the IC. The default selection signal may indicate one of the test outputs as a default test output. The diagnostic circuit may identify one or more defective cores from the identical cores based on the test outputs and the default selection signal. The diagnostic circuit may further output defective test outputs generated by the one or more defective cores. Further, the diagnostic circuit may provide the defective test outputs as failure logs to the test system.

In contrast to conventional solutions, the diagnostic circuit of the present disclosure provides the failure logs to the test system without any need for additional test patterns. Thus, the need to generate additional test patterns is eliminated. Moreover, the same output pads are used to provide the failure logs of all the defective cores thereby mitigating the need for dedicated output pads for each identical core. As a result, the design complexity and a manufacturing cost of the IC of the present disclosure are less as compared to conventional ICs. The disclosed IC thus facilitates efficient testing of identical cores.

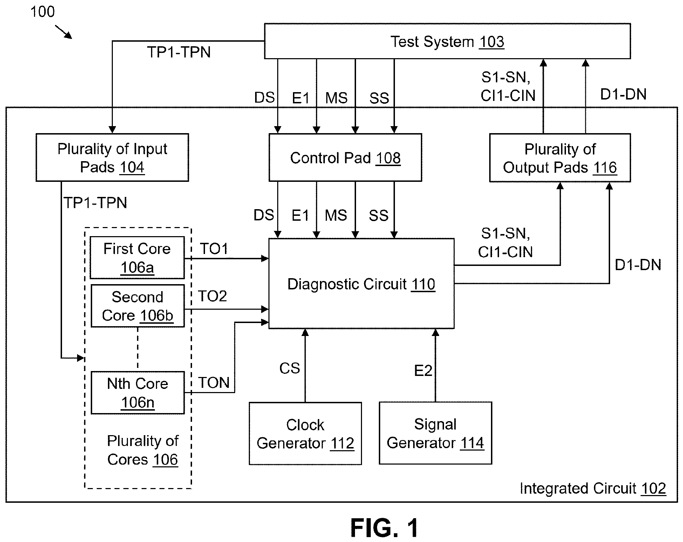

FIG. 1 illustrates a schematic diagram of a testing environment 100 in accordance with an embodiment of the present disclosure. The testing environment 100 is shown to include an integrated circuit (IC) 102 and a test system 103. The testing environment 100 facilitates testing of the IC 102 by way of the test system 103. The IC 102 may be tested to functionally verify and validate a performance of the IC 102. Further, the IC 102 may be tested prior to being implemented in an electronic device. Examples of the electronic device include mobile devices, wearables, networking devices, or the like.

### IC 102:

The IC 102 may include a plurality of input pads 104, a plurality of cores 106, a control pad 108, a diagnostic circuit 110, a clock generator 112, a signal generator 114, and a plurality of output pads 116. The IC 102 may be configured to receive a plurality of test patterns TP1-TPN to facilitate testing of the IC 102 (e.g., the plurality of cores 106). For the sake of ongoing description, the testing of the IC 102 refers to testing of the plurality of cores 106.

### Plurality of input pads 104:

The plurality of input pads 104 may be coupled to the test system 103 and the plurality of cores 106. Each input pad of the plurality of input pads 104 may include suitable circuitry that may be configured to perform one or more operations. For example, the plurality of input pads 104 may be an interface (e.g., a plurality of general-purpose input-output (GPIO) pins) between the test system 103 and the plurality of cores 106. Thus, the plurality of input pads 104 may be configured to receive, from the test system 103, the plurality of test patterns TP1-TPN. Further, the plurality of input pads 104 may be configured to provide the plurality of test patterns TP1-TPN to the plurality of cores 106. Examples of the plurality of input pads 104 include, but are not limited to, a Joint Test Action Group (JTAG) interface, a serial peripheral interface, an on-die interface, an advanced peripheral bus, a scan path control, or the like. A number of the plurality of input pads 104 is lower than a number of input pads in conventional ICs. In an example, for three identical cores in a conventional IC, five input pads are associated with each core. Thus, fifteen input pads (e.g., five input pads associated with each core) are utilized to receive test patterns. However, for any number of identical cores in the IC 102, the same five input pads are utilized to receive the plurality of test patterns TP1-TPN.

### Plurality of cores 106:

The plurality of cores 106 may be tested to functionally verify, assure quality, validate a performance, ensure compliance, and the like, of the IC 102. Each core of the plurality of cores 106 may be configured to perform one or more operations such as an arithmetic operation, a logic operation, a control operation, an encoding operation, a decoding operation, signal processing, or the like. Further, each of the plurality of cores 106 may have an identical design. As the plurality of cores 106 have an identical design, each core may be tested by way of the plurality of test patterns TP1-TPN.

The plurality of cores 106 may include a first core 106a, a second core 106b, ......, and an nth core 106n. Additionally, each core of the plurality of cores 106 may be coupled to the plurality of input pads 104 and the diagnostic circuit 110. The plurality of cores 106 may be configured to perform one or more operations. For example, the plurality of cores 106 may be configured to receive the plurality of test patterns TP1-TPN from the plurality of input pads 104 and generate a plurality of test outputs TO1-TON. In an example, each core may be configured to generate a respective test output of the plurality of test outputs TO1-TON based on the received plurality of test patterns TP1-TPN. Further, each core may be configured to provide a corresponding test output of the plurality of test outputs TO1-TON to the diagnostic circuit 110. In an example, the first core 106a and the second core 106b may receive the plurality of test patterns TP1-TPN. Further, the first core 106a and the second core 106b may generate a first test output TO1 and a second test output TO2, respectively, of the plurality of test outputs TO1-TON, based on the received plurality of test patterns TP1-TPN. The plurality of cores 106 may be associated with a plurality of core identifiers. Thus, each core may be identified by way of a corresponding core identifier. A core identifier may correspond to an alphabetical value, a numerical value, or an alpha-numerical value.

In some embodiments, each core may be coupled to the diagnostic circuit 110 by way of a first data bus (not shown). In further embodiments, each core may be coupled to the plurality of input pads 104 by way of a second data bus (not shown) that may be identical to the first data bus. Further, a number of data lines in the second data bus may be either greater than or less than a number of data lines in the first data bus.

### Control pad 108:

The control pad 108 may be coupled to the test system 103 and the diagnostic circuit 110. The control pad 108 may include suitable circuitry that may be configured to perform one or more operations. For example, the control pad 108 may be an interface (e.g. the GPIO pins) between the test system 103 and the diagnostic circuit 110. Further, the control pad 108 may be configured to configure communication parameters between the test system 103 and the diagnostic circuit 110.

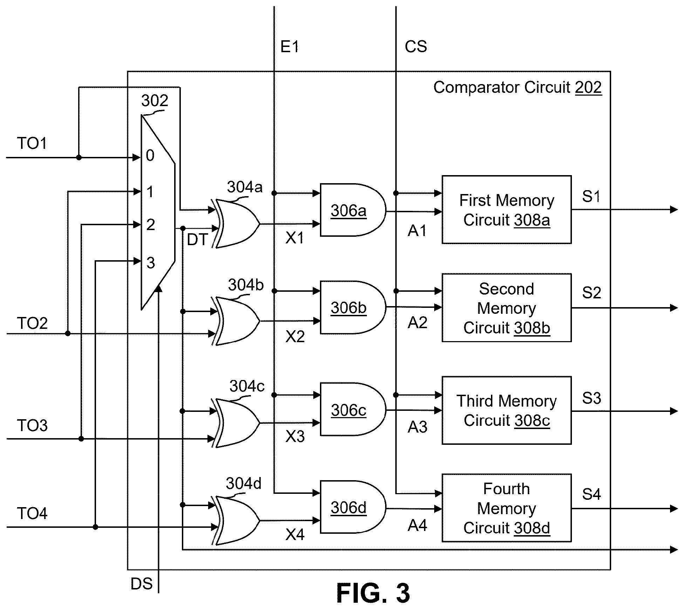

The control pad 108 may be further configured to receive the first enable signal E1 and a default selection signal DS from the test system 103, and provide the first enable signal E1 and the default selection signal DS to the diagnostic circuit 110. The operations triggered by the first enable signal E1 have been explained in detail in FIG. 3. The default selection signal DS may indicate one of the plurality of cores 106 as a default core to the diagnostic circuit 110. In other words, the default selection signal DS may indicate one of the plurality of test outputs TO1-TON as a default test output DT. In an example, the default selection signal DS may indicate the first test output TO1 as the default test output DT.

The control pad 108 may be configured to receive a mode signal MS and a select signal SS from the test system 103 and provide the mode signal MS and the select signal SS to the diagnostic circuit 110. The mode signal MS may be indicative of a mode of operation such as a default mode or a normal mode, of the diagnostic circuit 110. The default mode and the normal mode are explained in the ongoing description. Examples of the control pad 108 include, but are not limited to, a JTAG interface, a serial peripheral interface, an on-die interface, an advanced peripheral bus, a scan path control, or the like.

### Diagnostic circuit 110:

The diagnostic circuit 110 may be coupled to the plurality of cores 106, the control pad 108, the clock generator 112, the signal generator 114, and the plurality of output pads 116. The diagnostic circuit 110 may include suitable circuitry configured to perform one or more operations. For example, the diagnostic circuit 110 may be configured to receive the plurality of test outputs TO1-TON from the plurality of cores 106. The diagnostic circuit 110 may be further configured to receive the default selection signal DS from the test system 103. The default selection signal DS may indicate one of the plurality of cores 106 as the default core. In other words, the default selection signal DS may indicate one of the plurality of test outputs TO1-TON as the default test output DT. In an example, the default selection signal DS may indicate the first core 106a as the default core. Thus, the default selection signal DS may indicate the first test output TO1 as the default test output DT.

The diagnostic circuit 110 may be further configured to receive, a clock signal CS from the clock generator 112 and the first enable signal E1 from the test system 103 by way of the control pad 108. The diagnostic circuit 110 may be further configured to compare each test output of the plurality of test outputs TO1-TON with the default test output DT based on the first enable signal E1. In an example, the first test output TO1 may be the default test output DT. Further, the second test output TO2 may be compared with the first test output TO1 (e.g., the default test output DT) based on the first enable signal E1.

The diagnostic circuit 110 may be further configured to generate a plurality of status bits S1-SN based on the comparison and the clock signal CS. Each bit of the plurality of status bits S1-SN is indicative of a status of a corresponding core of the plurality of cores 106. Further, the status of a core may indicate one of a defective core or a non-defective core. A core may be a defective core when the core generates a test output that is different from the default test output DT. Alternatively, a core may be a non-defective core (e.g., operating normally) when the core generates a test output that is similar to the default test output DT. The diagnostic circuit 110 may be further configured to identify a defective set of cores of the plurality of cores 106 based on the plurality of status bits S1-SN. In other words, the diagnostic circuit 110 may identify the defective set of cores based on the plurality of test outputs TO1-TON and the default test output DT.

In some embodiments, a status bit of the plurality of status bits S1-SN being "1" may indicate that the corresponding core is a defective core whereas a status bit of the plurality of status bits S1-SN being "0" may indicate that the corresponding core is a non-defective core. In an example, the plurality of status bits S1-SN may indicate that the second core 106b is a defective core. Thus, a second status bit S2 of the plurality of status bits S1-SN may be "1". Thus, the diagnostic circuit 110 may identify the second core 106b as the defective core. In further embodiments, a status bit of the plurality of status bits S1-SN associated with the default core is "0" and the remaining status bits of the plurality of status bits S1-SN is "1". Thus, the diagnostic circuit 110 may identify the default core (for example, the first core 106a) as a defective core.

The diagnostic circuit 110 may be further configured to provide the generated plurality of status bits S1-SN to the test system 103 by way of the plurality of output pads 116. In response, the diagnostic circuit 110 may be configured to receive the mode signal MS from the test system 103 by way of the control pad 108.

The diagnostic circuit 110 may be further operable in the default mode or the normal mode based on the mode signal MS. The diagnostic circuit 110 may be operable in the default mode when the default core of the plurality of cores 106 is defective. For example, the first core 106a is the default core. Further, the first core 106a is the defective core. The diagnostic circuit 110 may thus be configured to operate in the default mode. Further, the diagnostic circuit 110 may be configured to operate in the normal mode when any core of the plurality of cores 106 apart from the default core is defective. For example, the diagnostic circuit 110 operates in the normal mode when any of the second core 106b through nth core 106n is a defective core and the first core 106a is a non-defective core.

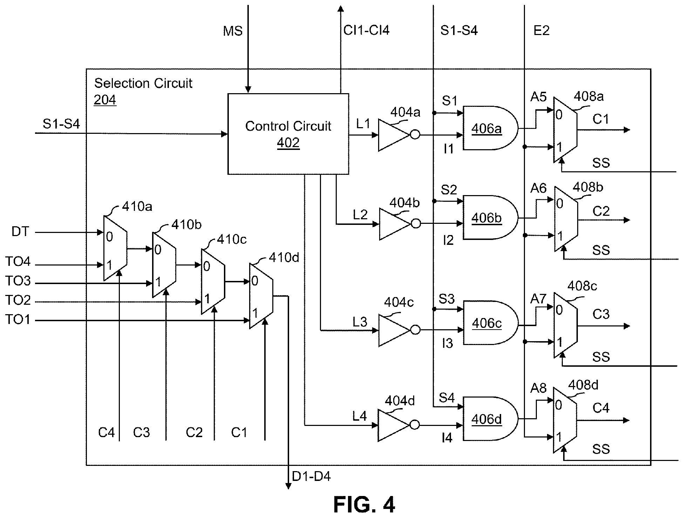

The diagnostic circuit 110 may be further configured to receive the select signal SS and a second enable signal E2 based on the plurality of status bits S1-SN, from the test system 103. The diagnostic circuit 110 may be further configured to output a set of defective outputs D1-DN associated with the defective set of cores as a set of failure logs based on the select signal SS and the second enable signal E2 as explained in detail in FIG. 4. Additionally, the diagnostic circuit 110 may be further configured to output a set of core identifiers CI1-CIN that is associated with the defective set of cores along with the set of failure logs. The set of core identifiers CI1-CIN may be provided to the test system 103 by way of the plurality of output pads 116.

### Default mode:

In the default mode of operation of the diagnostic circuit 110, the set of defective outputs D1-DN includes the default test output DT (e.g., the first test output TO1). Thus, the default test output DT and a core identifier (e.g., a core identifier CI1) of the default core (e.g., the first core 106a) are provided to the test system 103.

### Normal mode:

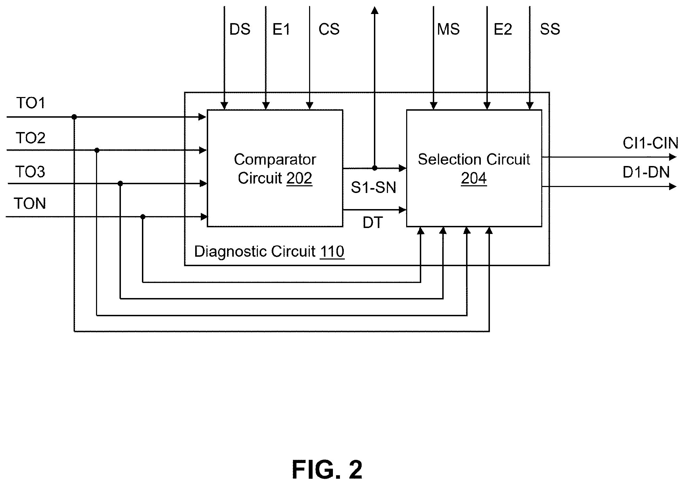

In the normal mode of operation of the diagnostic circuit 110, the set of defective outputs D1-DN and the set of core identifiers CI1-CIN are outputted in a set of iterations. A number of the set of iterations is based on a number of the defective outputs. In an example, the set of defective outputs D1-DN includes a defective output D2 and a defective output D4 that correspond to the second test output TO2 and the fourth test output TO4, respectively. Thus, the set of iterations includes two iterations of which the defective output D2 and the core identifier CI2 are outputted in a first iteration, and the defective output D4 and the core identifier CI4 are outputted in a second iteration. The diagnostic circuit 110 is further explained in detail in conjunction with FIG. 2.

### Clock generator 112:

The clock generator 112 may be coupled to the diagnostic circuit 110. The clock generator 112 may include suitable circuitry configured to perform one or more operations. For example, the clock generator 112 may be configured to generate the clock signal CS. The clock generator 112 may be further configured to provide the clock signal CS to the diagnostic circuit 110. Examples of the clock generator 112 may include a crystal oscillator, a phase-locked loop clock generator, or the like.

### Signal generator 114:

The signal generator 114 may be coupled to the diagnostic circuit 110. The signal generator 114 may include suitable circuitry configured to perform one or more operations. For example, the signal generator 114 may be configured to generate the second enable signal E2 to facilitate the testing of the plurality of cores 106. The signal generator 114 may be further configured to provide the second enable signal E2 to the diagnostic circuit 110. Examples of the signal generator 114 may include a waveform generator, a digital pattern generator, or the like.

### Plurality of output pads 116:

The plurality of output pads 116 may be coupled to the diagnostic circuit 110 and the test system 103. The plurality of output pads 116 may be an interface (e.g. the GPIO pins) between the test system 103 and the IC 102. The plurality of output pads 116 may be configured to receive the plurality of status bits S1-SN and provide the plurality of status bits S1-SN to the test system 103. Examples of the plurality of output pads 116 include, but are not limited to a JTAG interface, a serial peripheral interface, an on-die interface, an advanced peripheral bus, a scan path control, or the like.

### Default mode:

In the default mode, the plurality of output pads 116 may be configured to receive the default test output DT (e.g., the first test output TO1) and the core identifier (e.g., the core identifier CI1) of the default core, from the diagnostic circuit 110. Further, the plurality of output pads 116 may be configured to provide the default test output DT and the core identifier of the default core, to the test system 103.

### Normal mode:

In the normal mode, the plurality of output pads 116 may be configured to receive one of the set of defective outputs D1-DN in a corresponding iteration of the set of iterations. In an example, when the set of defective outputs D1-DN includes the defective output D2 and the defective output D4, the plurality of output pads 116 may receive the defective output D2 and the core identifier CI2 in the first iteration. Further, the plurality of output pads 116 may receive the defective output D4 and the core identifier CI4 in the second iteration. The plurality of output pads 116 may be further configured to provide the received defective output and the received core identifier to the test system 103 in the respective iteration. In an example, the plurality of output pads 116 may provide the defective output D2 and the core identifier CI2 to the test system 103 in the first iteration and the defective output D4 and the core identifier CI4 to the test system 103 in the second iteration.

### Set of output pads:

In some embodiments, the plurality of output pads 116 may include a first set of output pads and a second set of output pads. In the default mode, the first set of output pads may be configured to receive the default test output DT and the second set of output pads may be configured to receive the core identifier of the default core, from the diagnostic circuit 110. Further, the first set of output pads may be configured to provide the default test output DT as a failure log of the default core and the second set of output pads may be configured to provide the core identifier of the default core, to the test system 103. Further, in the normal mode, the first set of output pads may be configured to receive one of the set of defective outputs D1-DN in a corresponding iteration and the second set of output pads may be configured to receive the core identifier associated with the received defective output, in the corresponding iteration. The first set of output pads may be further configured to provide the received defective output and the second set of output pads may be further configured to provide the received core identifier, to the test system 103. A number of the plurality of output pads 116 is lower than a number of output pads in conventional ICs. In an example, for three identical cores in a conventional IC, three output pads are associated with each core. Thus, nine output pads (e.g., three output pads associated with each core) are utilized to provide failure logs to a test system. However, for any number of identical cores in the IC 102, the same four output pads are utilized to provide the set of failure logs to the test system 103.

### Test system 103:

The test system 103 may be coupled to the IC 102 by way of the plurality of input pads 104, the control pad 108, and the plurality of output pads 116. The test system 103 may include suitable circuitry that may be configured to perform one or more operations. For example, the test system 103 may facilitate the testing of the plurality of cores 106.

To facilitate the testing, the test system 103 may be configured to generate the plurality of test patterns TP1-TPN, and the test system 103 may provide the plurality of test patterns TP1-TPN to the IC 102. Examples of the plurality of test patterns TP1-TPN may include functional test patterns, scan test patterns, random test patterns, or the like. Additionally, the test system 103 may be configured to generate and provide the first enable signal E1 to the IC 102. The test system 103 may be further configured to generate and provide, the default selection signal DS to the IC 102. The default selection signal DS may indicate the default core.

Based on the plurality of test patterns TP1-TPN, the first enable signal E1, and the default selection signal DS, the test system 103 may be further configured to receive the plurality of status bits S1-SN from the IC 102. The test system 103 may be further configured to determine whether the default core is the defective core based on the plurality of status bits S1-SN and generate the mode signal MS based on the determination. The test system 103 may further provide the mode signal MS to the IC 102. Additionally, the test system 103 may be configured to generate and provide the select signal SS to the IC 102.

The test system 103 may be further configured to receive the set of defective outputs D1-DN as the set of failure logs associated with the defective set of cores based on the mode signal MS and the select signal SS. Additionally, the test system 103 may receive the set of core identifiers CI1-CIN associated with the defective set of cores. The set of failure logs may be utilized by the test system 103 to diagnose one or more defects associated with each defective core. In an example, the test system 103 may receive the defective output D2 as the failure log, and the core identifier CI2. The test system 103 may identify that the defective output D2 is associated with the second core 106b based on the core identifier CI2.

In some embodiments, the test system 103 corresponds to an automatic test pattern generator (ATPG) tool. Although not shown, the test system 103 may include various components to generate the afore-mentioned test patterns and signals. For example, the test system 103 may include a pattern generator to generate the plurality of test patterns TP1-TPN, and a test control circuit to generate the mode signal MS, the first enable signal E1, the default selection signal DS, and the select signal SS.

FIG. 2 illustrates a schematic block diagram of the diagnostic circuit 110 in accordance with an embodiment of the present disclosure. The diagnostic circuit 110 may include a comparator circuit 202 and a selection circuit 204.

### Comparator circuit 202:

The comparator circuit 202 may be coupled to each core of the plurality of cores 106, the control pad 108, the clock generator 112, the plurality of output pads 116, and the selection circuit 204. The comparator circuit 202 may include suitable circuitry configured to perform one or more operations. For example, the comparator circuit 202 may be configured to receive the plurality of test outputs TO1-TON from the plurality of cores 106. The comparator circuit 202 may be further configured to receive the default selection signal DS from the test system 103. The comparator circuit 202 may identify the default test output DT (e.g., one of the plurality of test outputs TO1-TON) based on the default selection signal DS.

The comparator circuit 202 may be further configured to compare each of the plurality of test outputs TO1-TON with the default test output DT as explained in detail in FIG. 3. The comparator circuit 202 may be further configured to receive the first enable signal E1 and the clock signal CS from the test system 103 and the clock generator 112, respectively. The comparator circuit 202 may be further configured to generate the plurality of status bits S1-SN based on the comparison, the first enable signal E1, and the clock signal CS, and provide the plurality of status bits S1-SN to the test system 103 and the selection circuit 204. The test system 103 may generate the mode signal MS based on the plurality of status bits S1-S4. The comparator circuit 202 may be further configured to provide the default test output DT to the selection circuit 204.

### Selection circuit 204:

The selection circuit 204 may be coupled to each core of the plurality of cores 106, the control pad 108, the signal generator 114, the plurality of output pads 116, and the comparator circuit 202. The selection circuit 204 may include suitable circuitry configured to perform one or more operations. For example, the selection circuit 204 may be configured to receive the plurality of status bits S1-SN and the default test output DT from the comparator circuit 202. The selection circuit 204 may be further configured to receive the plurality of test outputs TO1-TON from the plurality of cores 106. The selection circuit 204 may be further configured to receive the mode signal MS and the select signal SS from the control pad 108. The selection circuit 204 may operate in the normal mode or the default mode based on the mode signal MS. The selection circuit 204 may operate in the normal mode when the mode signal MS is asserted. Further, the selection circuit 204 may operate in the default mode when the mode signal MS is de-asserted. The selection circuit 204 may be further configured to receive the second enable signal E2 from the signal generator 114. The selection circuit 204 may be further configured to output the set of defective outputs D1-DN and the set of core identifiers CI1-CIN based on the plurality of status bits S1-SN, the second enable signal E2, and the select signal SS. The selection circuit 204 is further explained in detail in conjunction with FIG. 4.

### Default mode:

When the mode signal MS is indicative of the default mode, the selection circuit 204 may output the default test output DT and the core identifier associated with the default core to the test system 103 by way of the plurality of output pads 116. For example, when the first core 106a is the default core, the selection circuit 204 may output the first test output TO1 and a core identifier CI1 that is associated with the first core 106a.

### Normal Mode:

When the mode signal MS is indicative of the normal mode, the selection circuit 204 may output the set of defective outputs D1-DN and the set of core identifiers CI1-CIN in the set of iterations. Thus, with each iteration, the selection circuit 204 may output a corresponding defective output of the set of defective outputs D1-DN and a corresponding core identifier of the set of core identifiers CI1-CIN.

FIG. 3 illustrates a schematic block diagram of the comparator circuit 202 in accordance with an embodiment of the present disclosure. For the sake of ongoing discussion, the plurality of cores 106 are shown to include four cores. Thus, for sake of explaining FIG. 3, the plurality of test outputs TO1-TON are referred to as a "plurality of test outputs TO1-TO4" and the plurality of status bits S1-SN are referred to as a "plurality of status bits S1-S4".

The comparator circuit 202 may include a multiplexer 302, a plurality of exclusive-OR (XOR) gates 304a-304d, a first plurality of AND gates 306a-306d, and a plurality of memory circuits 308a-308d. The plurality of XOR gates 304a-304d may include first through fourth XOR gates 304a-304d. Further, the first plurality of AND gates 306a-306d may include first through fourth AND gates 306a-306d. Additionally, the plurality of memory circuits 308a-308d may include first through fourth memory circuits 308a-308d.

### Multiplexer 302:

The multiplexer 302 may be coupled to the plurality of cores 106, the plurality of AND gates 306a-306d, the plurality of input pads 104, and the selection circuit 204. The multiplexer 302 may include suitable circuitry configured to perform one or more operations. For example, the multiplexer 302 may be configured to receive the plurality of test outputs TO1-TO4 and the default selection signal DS. The multiplexer 302 may include four data input terminals (e.g., "0", "1", "2", and "3") to receive each of the plurality of test outputs TO1-TO4. The default selection signal DS may indicate a test output of the plurality of test outputs TO1-TO4. The multiplexer 302 may be further configured to output one of the plurality of test outputs TO1-TO4 as the default test output DT based on the default selection signal DS. The default test output DT is provided to the plurality of XOR gates 304a-304d and the selection circuit 204. In some embodiments, the plurality of test outputs TO1-TO4 correspond to data inputs of the default multiplexer 302 and the default selection signal DS corresponds to a select input of the default multiplexer 302. Further, the default test output DT corresponds to an output of the default multiplexer 302. For the sake of ongoing discussion, it is assumed that the first test output TO1 is the default test output DT. As the multiplexer 302 selects the default test output DT, the multiplexer 302 may be hereinafter referred to as a "default multiplexer 302".

### First XOR gate 304a:

The first XOR gate 304a may be coupled to the first core 106a of the plurality of cores 106, the default multiplexer 302, and the first AND gate 306a. The first XOR gate 304a may include suitable circuitry configured to perform one or more operations. For example, the first XOR gate 304a may be configured to receive the first test output TO1 and the default test output DT as inputs. The first test output TO1 may be received from the first core 106a and the default test output DT may be received from the default multiplexer 302. The first XOR gate 304a may be further configured to perform an XOR operation based on the inputs. The first XOR gate 304a may be further configured to output a first XOR signal X1 of a plurality of XOR signals X1-X4 based on the XOR operation. An XOR gate is configured to compare the received inputs and output an XOR signal based on the comparison. The XOR signal may be asserted when the inputs are different from each other (e.g., the first test output TO1 is different than the default test output DT), whereas the XOR signal may be de-asserted when the inputs are identical (e.g., the first test output TO1 matches the default test output DT). In some embodiments, the first XOR signal X1 may be de-asserted based on the assumption that the first test output TO1 is the default test output DT.

### Second XOR gate 304b:

The second XOR gate 304b may be coupled to the second core 106b, the default multiplexer 302, and the second AND gate 306b. The second XOR gate 304b may include suitable circuitry configured to perform one or more operations. For example, the second XOR gate 304b may be configured to receive the second test output TO2 of the plurality of test outputs TO1-TO4 and the default test output DT as inputs. The second test output TO2 may be received from the second core 106b and the default test output DT may be received from the default multiplexer 302. The second XOR gate 304b may be further configured to perform an XOR operation based on the inputs. The second XOR gate 304b may be further configured to output a second XOR signal X2 of the plurality of XOR signals X1-X4 based on the XOR operation. The second XOR signal X2 may be de-asserted when the second test output TO2 is identical to the default test output DT. In an example, when the second core 106b is operating normally, the second test output TO2 is similar to (e.g., matches) the default test output DT. Thus, the second XOR signal X2 may be de-asserted. Alternatively, the second XOR signal X2 may be asserted when the second test output TO2 is different from the default test output DT. In an example, when the second core 106b is a defective core, the second test output TO2 is different from the default test output DT. Thus, the second XOR signal X2 may be asserted.

### Third XOR gate 304c:

The third XOR gate 304c may be coupled to the third core 106c, the default multiplexer 302, and the third AND gate 306c. The third XOR gate 304c may include suitable circuitry configured to perform one or more operations. For example, the third XOR gate 304c may be configured to receive a third test output TO3 of the plurality of test outputs TO1-TO4 and the default test output DT as inputs. The third test output TO3 may be received from the third core 106c and the default test output DT may be received from the default multiplexer 302. The third XOR gate 304c may be further configured to perform an XOR operation based on the inputs. The third XOR gate 304c may be further configured to output a third XOR signal X3 of the plurality of XOR signals X1-X4 based on the XOR operation. The third XOR signal X3 may be de-asserted when the third test output TO3 is identical to the default test output DT. Alternatively, the third XOR signal X3 may be asserted when the third test output TO3 is different from the default test output DT.

### Fourth XOR gate 304d:

The fourth XOR gate 304d may be coupled to the fourth core 106d, the default multiplexer 302, and the fourth AND gate 306d. The fourth XOR gate 304d may include suitable circuitry configured to perform one or more operations. For example, the fourth XOR gate 304d may be configured to receive a fourth test output TO4 of the plurality of test outputs TO1-TO4 and the default test output DT as inputs. The fourth XOR gate 304d may be further configured to perform an XOR operation based on the inputs. The fourth XOR gate 304d may be further configured to output a fourth XOR signal X4 of the plurality of XOR signals X1-X4 based on the XOR operation. The fourth XOR signal X4 may be de-asserted when the fourth test output TO4 is identical to the default test output DT. Alternatively, the fourth XOR signal X4 may be asserted when the fourth test output TO4 is different from the default test output DT.

### First AND gate 306a:

The first AND gate 306a may be coupled to the control pad 108, the first XOR gate 304a, and the first memory circuit 308a. The first AND gate 306a may include suitable circuitry configured to perform one or more operations. For example, the first AND gate 306a may be configured to receive the first XOR signal X1 and the first enable signal E1 as inputs. The first XOR signal X1 may be received from the first XOR gate 304a and the first enable signal E1 may be received from the control pad 108. The first AND gate 306a may be further configured to perform an AND operation based on the inputs. The first AND gate 306a may be further configured to output a first AND signal A1 of a first plurality of AND signals A1-A4 based on the AND operation. In an example, when the first enable signal E1 is asserted and the first XOR signal X1 is de-asserted, the first AND signal A1 may be de-asserted. Thus, the first AND signal A1 is de-asserted when the first test output TO1 matches the default test output DT.

### Second AND gate 306b:

The second AND gate 306b may be coupled to the control pad 108, the second XOR gate 304b, and the second memory circuit 308b. The second AND gate 306b may include suitable circuitry configured to perform one or more operations. For example, the second AND gate 306b may be configured to receive the second XOR signal X2 and the first enable signal E1 as inputs. The second XOR signal X2 may be received from the second XOR gate 304b and the first enable signal E1 may be received from the control pad 108. The second AND gate 306b may be further configured to perform an AND operation based on the inputs. The second AND gate 306b may be further configured to output a second AND signal A2 of the first plurality of AND signals A1-A4 based on the AND operation. In an example, when the first enable signal E1 is asserted and the second XOR signal X2 is asserted, the second AND signal A2 may be asserted. Further, the second AND signal A2 is asserted when the second test output TO2 is different than the default test output DT.

### Third AND gate 306c:

The third AND gate 306c may be coupled to the control pad 108, the third XOR gate 304c, and the third memory circuit 308c. The third AND gate 306c may include suitable circuitry configured to perform one or more operations. For example, the third AND gate 306c may be configured to receive the third XOR signal X3 and the first enable signal E1 as inputs. The third XOR signal X3 may be received from the third XOR gate 304c and the first enable signal E1 may be received from the control pad 108. The third AND gate 306c may be further configured to perform an AND operation based on the inputs. The third AND gate 306c may be further configured to output a third AND signal A3 of the first plurality of AND signals A1-A4 based on the AND operation.

### Fourth AND gate 306d:

The fourth AND gate 306d may be coupled to the control pad 108, the fourth XOR gate 304d, and the fourth memory circuit 308d. The fourth AND gate 306d may include suitable circuitry configured to perform one or more operations. For example, the fourth AND gate 306d may be configured to receive the fourth XOR signal X4 and the first enable signal E1 as inputs. The fourth AND gate 306d may be further configured to perform an AND operation based on the inputs. The fourth AND gate 306d may be further configured to output a fourth AND signal A4 of the first plurality of AND signals A1-A4 based on the AND operation.

### First memory circuit 308a:

The first memory circuit 308a may be coupled to the first AND gate 306a, the clock generator 112, the plurality of output pads 116, and the selection circuit 204. The first memory circuit 308a may include suitable circuitry configured to perform one or more operations. For example, the first memory circuit 308a may be configured to receive the first AND signal A1 and the clock signal CS as inputs. The first AND signal A1 may be received from the first AND gate 306a and the clock signal CS may be received from the clock generator 112. The first memory circuit 308a may be further configured to generate a first status bit S1 of the plurality of status bits S1-S4 based on the inputs. In an example, the first status bit S1 is de-asserted when the first AND signal A1 is de-asserted. The first memory circuit 308a may be further configured to output the generated first status bit S1. The first status bit S1 may be provided to the test system 103 by way of the plurality of output pads 116 and the selection circuit 204.

### Second memory circuit 308b:

The second memory circuit 308b may be coupled to the second AND gate 306b, the clock generator 112, the plurality of output pads 116, and the selection circuit 204. The second memory circuit 308b may include suitable circuitry configured to perform one or more operations. For example, the second memory circuit 308b may be configured to receive the second AND signal A2 and the clock signal CS as inputs. The second AND signal A2 may be received from the second AND gate 306b and the clock signal CS may be received from the clock generator 112. The second memory circuit 308b may be further configured to generate the second status bit S2 of the plurality of status bits S1-S4 based on the inputs. The second memory circuit 308b may be further configured to output the generated second status bit S2. The second status bit S2 may be provided to the test system 103 by way of the plurality of output pads 116 and the selection circuit 204. In an example, the second status bit S2 is asserted when the second AND signal A2 is asserted. Further, the second status bit S2 is asserted when the second core 106b is a defective core.

### Third memory circuit 308c:

The third memory circuit 308c may be coupled to the third AND gate 306c, the clock generator 112, the plurality of output pads 116, and the selection circuit 204. The third memory circuit 308c may include suitable circuitry configured to perform one or more operations. For example, the third memory circuit 308c may be configured to receive the third AND signal A3 and the clock signal CS as inputs. The third AND signal A3 may be received from the third AND gate 306c and the clock signal CS may be received from the clock generator 112. The third memory circuit 308c may be further configured to generate a third status bit S3 of the plurality of status bits S1-S4 based on the inputs. The third memory circuit 308c may be further configured to output the generated third status bit S3. The third status bit S3 may be provided to the test system 103 by way of the plurality of output pads 116 and the selection circuit 204. In an example, the third status bit S3 is de-asserted when the third AND signal A3 is de-asserted. Further, the third status bit S3 is de-asserted when the third core 106c is functioning normally.

### Fourth memory circuit 308d:

The fourth memory circuit 308d may be coupled to the fourth AND gate 306d, the clock generator 112, the plurality of output pads 116, and the selection circuit 204. The fourth memory circuit 308d may include suitable circuitry configured to perform one or more operations. For example, the fourth memory circuit 308d may be configured to receive the fourth AND signal A4 and the clock signal CS as inputs. The fourth AND signal A4 may be received from the fourth AND gate 306d and the clock signal CS may be received from the clock generator 112. The fourth memory circuit 308d may be further configured to generate a fourth status bit S4 of the plurality of status bits S1-S4 based on the inputs. The fourth memory circuit 308d may be further configured to output the generated fourth status bit S4. The fourth status bit S4 may be provided to the test system 103 by way of the plurality of output pads 116, and the selection circuit 204. Examples of the first through fourth memory circuits 308a-308d may include but are not limited to, flipflops, latches, registers, or the like.

Although FIG. 3 illustrates that the comparator circuit 202 includes four XOR gates of the plurality of XOR gates 304a-304d, the scope of the present disclosure is not limited to it. In additional embodiments, the comparator circuit 202 may include greater than or less than four XOR gates based on the number of cores in the plurality of cores 106, without deviating from the scope of the present disclosure.

Although FIG. 3 illustrates that the comparator circuit 202 includes four AND gates of the first plurality of AND gates 306a-306d, the scope of the present disclosure is not limited to it. In further additional embodiments, the comparator circuit 202 may include greater than or less than four AND gates based on the number of cores in the plurality of cores 106, without deviating from the scope of the present disclosure.

Although FIG. 3 illustrates that the comparator circuit 202 includes four memory circuits of the plurality of memory circuits 308a-308d, the scope of the present disclosure is not limited to it. In numerous additional embodiments, the comparator circuit 202 may include greater than or less than four memory circuits based on the number of cores in the plurality of cores 106 without deviating from the scope of the present disclosure.

FIG. 4 illustrates a schematic block diagram of the selection circuit 204 in accordance with an embodiment of the present disclosure. The selection circuit 204 may include a control circuit 402, a plurality of inverters 404a-404d, a second plurality of AND gates 406a-406d, a plurality of control multiplexers 408a-408d, and a plurality of expose multiplexers 410a-410d. Each of the plurality of control multiplexers 408a-408d and each of the plurality of expose multiplexers 410a-410d may include two data input terminals (e.g., "0" and "1") and a select terminal. A first data input may be received at a first input terminal ("0") and a second data input may be received at a second input terminal ("1"). For the sake of ongoing discussion, the plurality of cores 106 are assumed to include four cores. Thus, the set of core identifiers CI1-CIN is referred to as "the set of core identifiers CI1-CI4".

The plurality of inverters 404a-40d may include first through fourth inverters 404a-404d. Further, the second plurality of AND gates 406a-406d may include fifth through eighth AND gates 406a-406b. Additionally, the plurality of control multiplexers 408a-408d may include first through fourth control multiplexers 408a-408d, and the plurality of expose multiplexers 410a-410d may include a default expose multiplexer 410a, a first expose multiplexer 410b, a second expose multiplexer 410c, and a third expose multiplexer 410d. Further, the default expose multiplexer 410a precedes the first expose multiplexer 410b, the first expose multiplexer 410b precedes the second expose multiplexer 410c, and the second expose multiplexer 410c precedes the third expose multiplexer 410d as shown in the FIG. 4.

### Control circuit 402:

The control circuit 402 may be coupled to the plurality of memory circuits 308a-308d, the control pad 108, the plurality of output pads 116, and the plurality of inverters 404a-404d. The control circuit 402 may include suitable circuitry that may be configured to perform one or more operations. For example, the control circuit 402 may be configured to receive the plurality of status bits S1-S4 from the plurality of memory circuits 308a-308d. The control circuit 402 may be further configured to receive the mode signal MS from the test system 103 by way of the control pad 108. The selection circuit 204 may operate in the normal mode or the default mode based on the mode signal MS. For example, the selection circuit 204 may operate in the default mode based on a de-asserted state of the mode signal MS and may operate in the normal mode based on an asserted state of the mode signal MS.

### Default mode:

When the mode signal MS is indicative of the default mode, the control circuit 402 may be configured to output a plurality of logic signals L1- L4 associated with the plurality of cores 106 based on the plurality of status bits S1-S4. Each logic signal of the plurality of logic signals L1-L4 may be asserted. For example, the first core 106a is the default core. Thus, each logic signal may be asserted when the first status bit S1 is de-asserted and the second through fourth status bits S2-S4 are asserted. In other words, the control circuit 402 may assert each logic signal to output the default test output DT as the failure log of the default core (e.g., the first core 106a). The control circuit 402 may be further configured to provide a core identifier that may be indicative of the core associated with the default test output DT. For example, the control circuit 402 may output the core identifier CI1 associated with the first core 106a when the first core 106a is the default core.

### Normal Mode:

When the mode signal MS is indicative of the normal mode, the control circuit 402 may be configured to output the plurality of logic signals L1- L4 at each iteration. The control circuit 402 may be further configured to provide a corresponding core identifier at each iteration to the test system 103 by way of the plurality of output pads 116. In the first iteration, each logic signal of the plurality of logic signals L1-L4 may be de-asserted (e.g., 0000). Further, one of the set of core identifiers CI1-CI4 associated with a least significant status bit (LSB) of the plurality of status bits S1-S4 that is asserted is provided in the first iteration. For example, it is assumed that the plurality of status bits S1-S4 may be represented as '0101' where the bit at the left end corresponds to a LSB and the bit at the right end corresponds to a most significant bit (MSB). In other words, the first status bit S1 may correspond to the LSB and the fourth status bit S4 may correspond to the MSB. In such an example, the core identifier CI2 associated with the second core 106b of the plurality of cores 106 is provided in the first iteration.

In each remaining iteration of the set of iterations, the plurality of logic signals L1-L4 are outputted such that a logic signal associated with a core identifier outputted in a preceding iteration is asserted. For example, when the core identifier CI2 of the second core 106b is outputted in the first iteration of the set of iterations, a second logic signal L2 of the plurality of logic signals L1-L4 (e.g., 0100) may be asserted in a second iteration. Further, in each remaining iteration, a core identifier of the set of core identifiers CI1-CI4 associated with a status bit that (i) is asserted and (ii) succeeds the status bit (e.g. the MSBs) associated with the core identifier outputted in the preceding iteration, is provided by the control circuit 402. In the above example, the plurality of status bits S1-S4 are represented as '0101' and the core identifier C12 of the second core 106b is outputted in the first iteration as the second status bit S2 is asserted. Thus, the core identifier CI4 is provided in the second iteration as the fourth status bit S4 is asserted and succeeds the second status bit.

In some embodiments, the control circuit 402 may include a counter that may be configured with a count based on a number of asserted bits in the plurality of status bits S1-S4 (e.g., the number of defective cores). In one example, the control circuit 402 may decrement the count of the counter by "1" upon outputting the plurality of logic signals L1- L4 and a core identifier of the set of core identifiers CI1-CI4. The control circuit 402 may output the plurality of logic signals L1-L4 and a core identifier of the set of core identifiers CI1-CI4 until the count is zero.

### First inverter 404a:

The first inverter 404a may be coupled to the control circuit 402 and the fifth AND gate 406a. The first inverter 404a may be configured to receive a first logic signal L1 of the plurality of logic signals L1-L4 from the control circuit 402. The first inverter 404a may be further configured to invert the first logic signal L1. The first inverter 404a may be further configured to output a first inverted signal I1. In an example, in the default mode, the first inverted signal I1 may be de-asserted when the first logic signal L1 is asserted. Further, in the normal mode, the first inverted signal I1 may be asserted in the first iteration as the first logic signal L1 is de-asserted.

### Second inverter 404b:

The second inverter 404b may be coupled to the control circuit 402 and a sixth AND gate 406b. The second inverter 404b may be configured to receive a second logic signal L2 of the plurality of logic signals L1-L4 from the control circuit 402. The second inverter 404b may be further configured to invert the second logic signal L2. The second inverter 404b may be further configured to output a second inverted signal I2. In an example, in the default mode, the second inverted signal I2 may be de-asserted as the second logic signal L2 is asserted. Further, in the normal mode, the second inverted signal I2 may be asserted in the first iteration as the second logic signal L2 is de-asserted. Further, the second inverted signal I2 may be de-asserted in the second iteration based on the second logic signal L2 being asserted when the second core 106b is the defective core and the defective output D2 is provided to the test system 103 in the first iteration.

### Third inverter 404c:

The third inverter 404c may be coupled to the control circuit 402 and a seventh AND gate 406c. The third inverter 404c may be configured to receive a third logic signal L3 of the plurality of logic signals L1-L4 from the control circuit 402. The third inverter 404c may be further configured to invert the third logic signal L3. The third inverter 404c may be further configured to output a third inverted signal 13. In the default mode, the third inverted signal I3 may be de-asserted as the third logic signal L3 is asserted. In the normal mode, the third inverted signal I3 may be asserted in the first iteration as the third logic signal L3 is de-asserted. Further, the third inverted signal I3 may be asserted in the second iteration based on the third logic signal L3 being de-asserted when the second core 106b and the fourth core 106d are defective cores and the third core 106c is a non-defective core.

### Fourth inverter 404d:

The fourth inverter 404d may be coupled to the control circuit 402 and an eighth AND gate 406d. The fourth inverter 404d may be configured to receive a fourth logic signal L4 of the plurality of logic signals L1-L4 from the control circuit 402. The fourth inverter 404d may be further configured to invert the fourth logic signal L4. The fourth inverter 404d may be further configured to output a fourth inverted signal I4.

In an exemplary scenario, in the default mode, when the first core 106a is the default core, the first through fourth inverted signals 11-14 may have values as "0000".

In a further exemplary scenario, in the normal mode, the plurality of inverters 404a-404d output the first through fourth inverted signals I1-I4 for each iteration of the set of iterations. When the second core 106b and the fourth core 106d are defective, the first through fourth inverted signals 11-14 may have values as "1111". Further, in the second iteration, the first through fourth inverted signals 11-14 have values as "1011". It will be understood by a person skilled in the art that the values of the first through fourth inverted signals I1-I4 are indicative of a logic state of the first through fourth inverted signals 11-14.

### Fifth AND gate 406a:

The fifth AND gate 406a may be coupled to the comparator circuit 202, the first inverter 404a, and the first control multiplexer 408a. The fifth AND gate 406a may be configured to receive the first inverted signal I1 and the first status bit S1 as inputs, from the first inverter 404a and the comparator circuit 202, respectively. The fifth AND gate 406a may be further configured to perform an AND operation on the inputs and output a fifth AND signal A5. In an example, the fifth AND signal A5 may be de-asserted when the first status bit S1 and the first inverted signal I1 are de-asserted.

### Sixth AND gate 406b:

The sixth AND gate 406b may be coupled to the comparator circuit 202, the second inverter 404b, and the second control multiplexer 408b. The sixth AND gate 406b may be configured to receive the second inverted signal I2 and the second status bit S2 as inputs, from the second inverter 404b and the comparator circuit 202, respectively. The sixth AND gate 406b may be further configured to perform an AND operation on the inputs and output a sixth AND signal A6.

### Seventh AND gate 406c:

The seventh AND gate 406c may be coupled to the comparator circuit 202, the third inverter 404c, and the third control multiplexer 408c. The seventh AND gate 406c may be configured to receive the third inverted signal I3 and the third status bit S3 as inputs, from the third inverter 404c and the comparator circuit 202, respectively. The seventh AND gate 406c may be further configured to perform an AND operation on the inputs and output a seventh AND signal A7.

### Eighth AND gate 406d:

The eighth AND gate 406d may be coupled to the comparator circuit 202, the fourth inverter 404d, and the fourth control multiplexer 408d. The eighth AND gate 406d may be configured to receive the fourth inverted signal I4 and the fourth status bit S4 as inputs, from the fourth inverter 404d and the comparator circuit 202, respectively. The eighth AND gate 406d may be further configured to perform an AND operation on the inputs and output an eighth AND signal A8.

In an exemplary scenario, in the default mode, when the first core 106a is the default core, the fifth through eighth AND signals A5-A8 may have values as "0000".

In a further exemplary scenario, in the normal mode, the second plurality of AND gates 406a-406d output the fifth through eighth AND signals A5-A8 for each iteration of the set of iterations. When the second core 106b and the fourth core 106d are defective, the fifth through eighth AND signals A5-A8 may have values as "0101". Further, in the second iteration, the fifth through eighth AND signals A5-A8 have values as "0001". It will be understood by a person skilled in the art that the values of the fifth through eighth AND signals A5-A8 are indicative of a logic state of the fifth through eighth AND signals A5-A8.

### First control multiplexer 408a:

The first control multiplexer 408a may be coupled to the fifth AND gate 406a, the signal generator 114, the control pad 108, and the third expose multiplexer 410d. The first control multiplexer 408a may be configured to receive the fifth AND signal A5, the second enable signal E2, and the select signal SS. The fifth AND signal A5 may be a first data input to the first control multiplexer 408a and the second enable signal E2 may be a second data input to the first control multiplexer 408a. Further, the select signal SS may be a select input to the first control multiplexer 408a where the select signal SS may be indicative of selecting one of the first data input and the second data input. The select signal SS may be received at the select terminal. Thus, the first control multiplexer 408a may be further configured to output one of the fifth AND signal A5 and the second enable signal E2 based on the select signal SS, as a first control signal C1. The select signal SS may be indicative of selecting the first data input when the selection circuit 204 is in the default mode. In an example, the first control signal C1 is de-asserted when the fifth AND signal A5 is de-asserted. The select signal SS may be indicative of selecting the first data input or the second data input when the selection circuit 204 is operating in the normal mode.

### Second control multiplexer 408b:

The second control multiplexer 408b may be coupled to the sixth AND gate 406b, the signal generator 114, the control pad 108, and the second expose multiplexer 410c. The second control multiplexer 408b may be configured to receive the sixth AND signal A6 as the first data input, the second enable signal E2 as the second data input, and the select signal SS. The second control multiplexer 408b may be further configured to output one of the sixth AND signal A6 and the second enable signal E2 based on the select signal SS, as a second control signal C2.

### Third control multiplexer 408c:

The third control multiplexer 408c may be coupled to the seventh AND gate 406c, the signal generator 114, the control pad 108, and the first expose multiplexer 410b. The third control multiplexer 408c may be configured to receive the seventh AND signal A7 as the first data input, the second enable signal E2 as the second data input, and the select signal SS. The third control multiplexer 408c may be further configured to output one of the seventh AND signal A7 and the second enable signal E2 based on the select signal SS, as a third control signal C3.

### Fourth control multiplexer 408d:

The fourth control multiplexer 408d may be coupled to the eighth AND gate 406d, the signal generator 114, the control pad 108, and the default expose multiplexer 410a. The fourth control multiplexer 408d may be configured to receive the eighth AND signal A8 as the first data input, the second enable signal E2 as the second data input, and the select signal SS. The fourth control multiplexer 408d may be further configured to output one of the eighth AND signal A8 and the second enable signal E2 based on the select signal SS, as a fourth control signal C4.

In an exemplary scenario, in the default mode, when the first core 106a is the default core, the first through fourth control signals C1-C4 may have values as "0000".

In a further exemplary scenario, in the normal mode, the plurality of control multiplexers 408a-408d output the first through fourth control signals C1-C4 for each iteration of the set of iterations. When the second core 106b and the fourth core 106d are defective, the first through fourth control signals C1-C4 may have values as "0101". Further, in the second iteration, the first through fourth control signals C1-C4 have values as "0001". It will be understood by a person skilled in the art that the values of the first through fourth control signals C1-C4 are indicative of a logic state of the first through fourth control signals C1-C4.

### Default expose multiplexer 410a:

The default expose multiplexer 410a may be coupled to the comparator circuit 202, the fourth core 106d, the fourth control multiplexer 408d, and the first expose multiplexer 410b. The default expose multiplexer 410a may be configured to receive the fourth test output TO4, the default test output DT, and the fourth control signal C4.

The default test output DT may be the first data input to the default expose multiplexer 410a and the fourth test output TO4 may be the second data input to the default expose multiplexer 410a. Further, the fourth control signal C4 may be a select input to the default expose multiplexer 410a where the fourth control signal C4 may be indicative of one of the first data input and the second data input. The fourth control signal C4 may be received at the select terminal as the select input. Thus, the default expose multiplexer 410a may be further configured to output one of the fourth test output TO4 and the default test output DT based on the fourth control signal C4. The default expose multiplexer 410a may provide one of the fourth test output TO4 and the default test output DT to the first expose multiplexer 410b.

### First expose multiplexer 410b:

The first expose multiplexer 410b may be coupled to the default expose multiplexer 410a. In other words, the first expose multiplexer 410b may be coupled to a preceding expose multiplexer of the plurality of expose multiplexers 410a-410d. The first expose multiplexer 410b may be further coupled to the third core 106c, the third control multiplexer 408c, and the second expose multiplexer 410c. The first expose multiplexer 410b may be configured to receive the output of the default expose multiplexer 410a (e.g., one of the default test output DT and the fourth test output TO4) as the first data input, the third test output TO3 as the second data input, and the third control signal C3. The first expose multiplexer 410b may be further configured to output one of the third test output TO3 and the output of the default expose multiplexer 410a based on the third control signal C3. The first expose multiplexer 410b may provide one of the third test output TO3 and the output of the default expose multiplexer 410a to the second expose multiplexer 410c.

### Second expose multiplexer 410c:

The second expose multiplexer 410c may be coupled to the first expose multiplexer 410b. In other words, the second expose multiplexer 410c may be coupled to a preceding expose multiplexer of the plurality of expose multiplexers 410a-410d. The second expose multiplexer 410c may be further coupled to the second core 106b, the second control multiplexer 408b, and the third expose multiplexer 410d. The second expose multiplexer 410c may be configured to receive the output of the first expose multiplexer 410b as the first data input, the second test output TO2 as the second data input, and the second control signal C2. The second expose multiplexer 410c may be further configured to output one of the second test output TO2 and the output of the first expose multiplexer 410b based on the second control signal C2. The second expose multiplexer 410c may provide one of the second test output TO2 and the output of the first expose multiplexer 410b to the third expose multiplexer 410d.

### Third expose multiplexer 410d:

The third expose multiplexer 410d may be coupled to the second expose multiplexer 410c. In other words, the third expose multiplexer 410d may be coupled to a preceding expose multiplexer of the plurality of expose multiplexers 410a-410d. The third expose multiplexer 410d may be further coupled to the first core 106a, the first control multiplexer 408a, and the plurality of output pads 116. The third expose multiplexer 410d may be configured to receive the output of the second expose multiplexer 410c as the first data input, the first test output TO1 as the second data input, and the first control signal C1. The third expose multiplexer 410d may be further configured to output one of the first test output TO1 and the output of the second expose multiplexer 410c based on the first control signal C1. The third expose multiplexer 410d may provide one of the first test output TO1 and the output of the second expose multiplexer 410c to the plurality of output pads 116.

### Default mode:

The first through fourth control signals C1-C4 may be de-asserted when the selection circuit 204 operates in the default mode. Thus, the default expose multiplexer 410a provides the default test output DT to the first expose multiplexer 410b. Further, the first expose multiplexer 410b provides the default test output DT to the second expose multiplexer 410c. Furthermore, the second expose multiplexer 410c provides the default test output DT to the third expose multiplexer 410d. As a result, the third expose multiplexer 410d provides the default test output DT to the plurality of output pads 116.

### Normal mode:

The first through fourth control signals C1-C4 are assumed as having values "0101" in the first iteration when the selection circuit 204 operates in the normal mode. Thus, the default expose multiplexer 410a provides the fourth test output TO4 to the first expose multiplexer 410b. Further, the first expose multiplexer 410b provides the fourth test output TO4 to the second expose multiplexer 410c. Furthermore, the second expose multiplexer 410c provides the second test output TO2 to the third expose multiplexer 410d. As a result, the third expose multiplexer 410d provides the second test output TO2 to the plurality of output pads 116, in the first iteration.

The first through fourth control signals C1-C4 may have the values "0001" in the second iteration of the set of iterations. Thus, the default expose multiplexer 410a provides the fourth test output TO4 to the first expose multiplexer 410b. Further, the first expose multiplexer 410b provides the fourth test output TO4 to the second expose multiplexer 410c. Furthermore, the second expose multiplexer 410c provides the fourth test output TO4 to the third expose multiplexer 410d. As a result, the third expose multiplexer 410d provides the fourth test output TO4 to the plurality of output pads 116, in the second iteration. Thus, a set of defective outputs D1-D4 is outputted by the selection circuit 204. The set of iterations in the above-described example includes two iterations as the defective set of cores includes two defective cores.

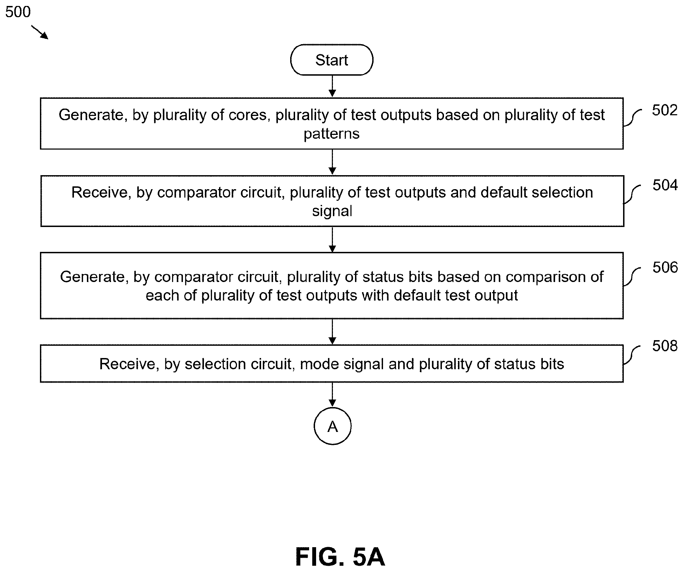

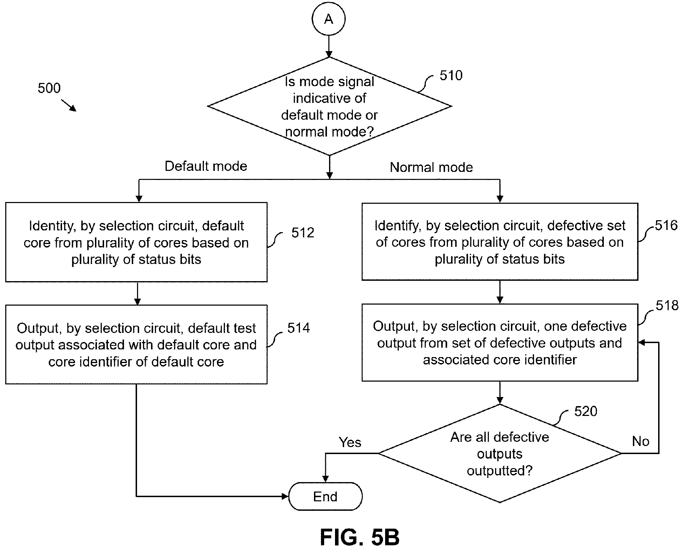

FIGS. 5A and 5B, collectively, represent a flowchart 500 that illustrates a diagnostic method executed by the IC 102 in accordance with an embodiment of the present disclosure. The flowchart 500 describes the operations performed by the IC 102.

Referring to FIG. 5A, at step 502, the plurality of cores 106 may generate the plurality of test outputs TO1-TON based on the plurality of test patterns TP1-TPN. Each core of the plurality of cores 106 may receive the plurality of test patterns TP1-TPN from the test system 103. Further, each core of the plurality of cores 106 may generate a respective test output based on the plurality of test patterns TP1-TPN. At step 504, the comparator circuit 202 may receive the plurality of test outputs TO1-TON from the plurality of cores 106 and the default selection signal DS. The default selection signal DS is indicative of the default test output DT. The default selection signal DS may be received from the test system 103. At step 506, the comparator circuit 202 may generate the plurality of status bits S1-SN based on the comparison of each of the plurality of test outputs TO1-TON with the default test output DT. The comparator circuit 202 may provide the plurality of status bits S1-S4 to the test system 103 and the selection circuit 204. At step 508, the selection circuit 204 may receive the mode signal MS and the plurality of status bits S1-SN.

Referring to FIG. 5B, at step 510, the selection circuit 204 may determine whether the mode signal MS is indicative of the default mode or the normal mode. When the mode signal MS is indicative of the default mode, steps 512 and 514 are executed. At step 512, the selection circuit 204 may identify the default core from the plurality of cores 106 based on the plurality of status bits S1-SN. At step 514, the selection circuit 204 may output the default test output DT associated with the default core and the core identifier of the default core.

At step 510, if the mode signal MS is indicative of the normal mode, steps 516-520 are executed. At step 516, the selection circuit 204 may identify the defective set of cores from the plurality of cores 106 based on the plurality of status bits S1-SN. At step 518, the selection circuit 204 may output a defective output from the set of defective outputs D1-DN associated with the defective set of cores and the associated core identifier of the set of core identifiers CI1-CI4. At step 520, the selection circuit 204 may determine whether all defective outputs of the set of defective outputs D1-DN are outputted. The selection circuit 204 may determine whether all defective outputs of the set of defective outputs D1-DN are outputted based on the count of the counter in the control circuit 402. Step 518 is executed when the count of the counter is greater than zero (e.g., all defective outputs of the set of defective outputs D1-DN are yet to be outputted). If at step 520, it is determined that all the set of defective outputs D1-DN are outputted, the process comes to a halt.

In the present disclosure, the term "assert" refers to placing a signal in a logic high state and the term "de-assert" refers to placing a signal in a logic low state.

The IC 102 disclosed in some embodiments of the present disclosure includes the diagnostic circuit 110 that identifies the defective set of cores from the plurality of cores 106 and outputs the set of defective test outputs D1-DN associated with the defective set of cores as the set of failure logs. The set of failure logs is provided to the test system 103. The diagnostic circuit 110 of the present disclosure provides the set of failure logs to the test system 103 based on the plurality of test patterns TP1-TPN thereby eliminating a need to generate additional test patterns by the test system 103. Further, the plurality of test patterns TP1-TPN remain unaltered to simultaneously test a large number of the identical plurality of cores 106. A processing overhead on the test system 103 is thus lower than the processing overhead that occurs due to conventional techniques of testing the ICs. Further, a testing time to test the IC 102 is reduced. In addition, the same plurality of output pads 116 are used to provide the failure logs of all the defective cores to the test system 103. Thus, the design complexity, a size and area, and the manufacturing cost of the IC 102 are reduced over conventional ICs which include output pads for each identical core.

In an embodiment of the present disclosure, an integrated circuit (IC) is disclosed. The IC may comprise a plurality of cores that may be identical. Each core of the plurality of cores may be configured to generate a respective test output based on a plurality of test patterns. The IC may further comprise a diagnostic circuit that may be coupled to the plurality of cores. The diagnostic circuit may be configured to receive (i) a plurality of test outputs that may include the test output of each of the plurality of cores and (ii) a default selection signal. The default selection signal may indicate one of the plurality of test outputs as a default test output. The diagnostic circuit may be further configured to identify, based on the plurality of test outputs and the default test output, a defective set of cores of the plurality of cores. The diagnostic circuit may be further configured to output a set of defective outputs associated with the defective set of cores as a set of failure logs.

In some embodiments, the plurality of test patterns may be associated with testing of the plurality of cores.

In some embodiments, the diagnostic circuit may further comprise a comparator circuit. The comparator circuit may be configured to receive the plurality of test outputs and the default selection signal. The diagnostic circuit may be further configured to compare each of the plurality of test outputs with the default test output. The diagnostic circuit may be further configured to generate a plurality of status bits based on the comparison, wherein the defective set of cores is identified based on the plurality of status bits.

In some embodiments, the comparator circuit may comprise a default multiplexer configured to receive (i) the plurality of test outputs and (ii) the default selection signal. The default multiplexer may be further configured to output one of the plurality of test outputs as the default test output based on the default selection signal.

In some embodiments, the comparator circuit may further comprise a plurality of exclusive-OR (XOR) gates coupled to the default multiplexer, wherein each XOR gate of the plurality of XOR gates may be configured to receive (i) a corresponding test output of the plurality of test outputs and (ii) the default test output. Each XOR gate of the plurality of XOR gates may be further configured to output one of a plurality of XOR signals based on the corresponding test output and the default test output.

In some embodiments, the comparator circuit may further comprise a first plurality of AND gates, wherein each AND gate of the first plurality of AND gates may be coupled to a corresponding XOR gate of the plurality of XOR gates. Each AND gate of the first plurality of AND gates may be configured to receive a corresponding XOR signal of the plurality of XOR signals and a first enable signal. Each AND gate of the first plurality of AND gates may be further configured to output one of a first plurality of AND signals based on the corresponding XOR signal and the first enable signal.

In some embodiments, the comparator circuit may further comprise a plurality of memory circuits, wherein each memory circuit of the plurality of memory circuits may be coupled to a corresponding AND gate of the first plurality of AND gates. Each memory circuit of the plurality of memory circuits may be configured to receive a corresponding AND signal of the first plurality of AND signals and a clock signal as inputs. Each memory circuit of the plurality of memory circuits may be further configured to generate a corresponding status bit of the plurality of status bits based on the inputs and output the generated status bit.

In some embodiments, the diagnostic circuit may further comprise a selection circuit that may be coupled to the comparator circuit. The selection circuit may be configured to receive the plurality of status bits, the plurality of test outputs, the default test output, and a mode signal, wherein the identification of the defective set of cores may be based on the plurality of status bits and the mode signal may be generated based on the plurality of status bits. The selection circuit may be further configured to output one of (i) in a set of iterations, the set of defective outputs and a set of core identifiers indicative of the defective set of cores when the mode signal indicates that the selection circuit operates in a normal mode. Further, in each iteration of the set of iterations, a corresponding defective output of the set of defective outputs and a corresponding core identifier of the set of core identifiers is outputted. The selection circuit may output a defective output that may correspond to the default test output and a core identifier that may be indicative of the core associated with the default test output when the mode signal may indicate that the selection circuit may operate in a default mode. The set of defective outputs may include the default test output.

In some embodiments, the IC may further comprise a plurality of output pads that may be coupled to the selection circuit, wherein the plurality of output pads may comprise a first set of output pads and a second set of output pads. In each iteration of the set of iterations, the first set of output pads may be configured to receive the corresponding defective output of the set of defective outputs. The first set of output pads may be further configured to provide the corresponding defective output from the IC to a test system. Additionally, in each iteration of the set of iterations, the second set of output pads may be configured to receive the corresponding core identifier associated with the corresponding defective output and provide the corresponding core identifier from the IC to the test system.

In some embodiments, the selection circuit may comprise a control circuit. When the selection circuit may operate in the normal mode, the control circuit may be configured to output, in a first iteration of the set of iterations, a plurality of logic signals that may be associated with the plurality of cores based on the plurality of status bits, wherein each of the plurality of logic signals may be de-asserted. In each remaining iteration of the set of iterations, the control circuit may be further configured to output the plurality of logic signals such that a logic signal associated with a core identifier of the set of core identifiers outputted in a preceding iteration of the set of iterations is asserted.

In some embodiments, each status bit of the plurality of status bits may be associated with a core of the plurality of cores, wherein a value of a status bit of the plurality of status bits may indicate that the core associated with the corresponding status bit may be defective. The control circuit may be further configured to provide, to a test system, in the first iteration, a core identifier of the set of core identifiers associated with a least significant bit of the plurality of status bits that is asserted. The control circuit may be further configured to provide in each remaining iteration of the set of iterations, a core identifier of the set of core identifiers associated with a status bit that is asserted and succeeds the status bit associated with the core identifier outputted in the preceding iteration.

In some embodiments, the selection circuit may further comprise a plurality of inverters that may be coupled to the control circuit, wherein the plurality of inverters may be associated with the plurality of cores. Each inverter of the plurality of inverters may be configured to receive a logic signal of the plurality of logic signals. Each inverter of the plurality of inverters may be further configured to invert the logic signal and output one of a plurality of inverted logic signals. The selection circuit may further comprise a second plurality of AND gates coupled to the plurality of inverters. The second plurality of AND gates may be associated with the plurality of cores. Each AND gate of the second plurality of AND gates may be configured to receive a corresponding status bit of the plurality of status bits and a corresponding inverted logic signal of the plurality of inverted logic signals. Each AND gate of the second plurality of AND gates may be further configured to output one of a second plurality of AND signals based on the corresponding status bit and the corresponding inverted logic signal.

In some embodiments, the selection circuit may further comprise a plurality of control multiplexers that may be coupled to the second plurality of AND gates. The plurality of control multiplexers may be associated with the plurality of cores. Each control multiplexer of the plurality of control multiplexers may be configured to receive a corresponding AND signal of the second plurality of AND signals, a second enable signal, and a select signal. Each control multiplexer of the plurality of control multiplexers may output one of a plurality of control signals based on the select signal.

In some embodiments, the selection circuit may further comprise a plurality of expose multiplexers that may be coupled to the plurality of control multiplexers and the plurality of cores and the selection circuit operates in the normal mode. A default expose multiplexer of the plurality of expose multiplexers may be configured to receive the default test output, a corresponding test output of the plurality of test outputs, and a corresponding control signal of the plurality of control signals. The default expose multiplexer may be further configured to output one of the default test output and the corresponding test output based on the corresponding control signal. Further, each remaining expose multiplexer of the plurality of expose multiplexers may be coupled to a preceding expose multiplexer of the plurality of expose multiplexers. Each remaining expose multiplexer of the plurality of expose multiplexers may be configured to receive a corresponding test output of the plurality of test outputs, a corresponding control signal of the plurality of control signals, and an output of the preceding expose multiplexer. Each remaining expose multiplexer may be further configured to output one of the corresponding test outputs and the output of the preceding expose multiplexer based on the corresponding control signal. A first expose multiplexer of the plurality of expose multiplexers may output a corresponding defective output of the set of defective outputs in a corresponding iteration of the set of iterations.

In some embodiments, the selection circuit may comprise a control circuit and the selection circuit may operate in the default mode. The control circuit may be configured to output a plurality of logic signals associated with the plurality of cores based on the plurality of status bits, wherein each of the plurality of logic signals may be asserted.

In some embodiments, the control circuit may be further configured to provide a core identifier of the set of core identifiers that may be indicative of the core associated with the default test output to a test system.

In some embodiments, the selection circuit may further comprise a plurality of inverters that may be coupled to the control circuit. The plurality of inverters may be associated with the plurality of cores. Each inverter of the plurality of inverters may be configured to receive a logic signal of the plurality of logic signals. Each inverter of the plurality of inverters may be further configured to invert the logic signal. Each inverter of the plurality of inverters may be further configured to output one of a plurality of inverted logic signals. The selection circuit may further comprise a second plurality of AND gates coupled to the plurality of inverters. The second plurality of AND gates may be associated with the plurality of cores. Each AND gate of the second plurality of AND gates may be configured to receive a corresponding status bit of the plurality of status bits and a corresponding inverted logic signal of the plurality of inverted logic signals. Each inverter of the plurality of inverters may be further configured to output one of a second plurality of AND signals based on the corresponding status bit and the corresponding inverted logic signal.

In some embodiments, the selection circuit may further comprise a plurality of control multiplexers that may be coupled to the second plurality of AND gates. The plurality of control multiplexers may be associated with the plurality of cores. Each control multiplexer of the plurality of control multiplexers may be configured to receive a corresponding AND signal of the second plurality of AND signals, a second enable signal, and a select signal. Each control multiplexer of the plurality of control multiplexers may be further configured to output one of a plurality of control signals based on the select signal.

In some embodiments, the selection circuit may further comprise a plurality of expose multiplexers that may be coupled to the plurality of control multiplexers and the plurality of cores. Further, the selection circuit operates in the default mode. A default expose multiplexer of the plurality of expose multiplexers may be configured to receive the default test output, a corresponding test output of the plurality of test outputs, and a corresponding control signal of the plurality of control signals. The default expose multiplexer may be further configured to output one of the default test outputs and the corresponding test output based on the corresponding control signal. Each remaining expose multiplexer of the plurality of expose multiplexers may be coupled to a preceding expose multiplexer of the plurality of expose multiplexers. Each remaining expose multiplexer of the plurality of expose multiplexers may be configured to receive a corresponding test output of the plurality of test outputs, a corresponding control signal of the plurality of control signals, and an output of the preceding expose multiplexer. Each remaining expose multiplexer of the plurality of expose multiplexers may be configured to output one of the corresponding test output and the output of the preceding expose multiplexer based on the corresponding control signal. A first expose multiplexer of the plurality of expose multiplexers outputs the defective output that may be associated with the default test output.

In another embodiment of the present disclosure, a diagnostic method is disclosed. The diagnostic method comprises generating, by each core of a plurality of cores of an integrated circuit (IC), a respective test output based on a plurality of test patterns. The plurality of cores may be identical. The diagnostic method may further comprise receiving, by a diagnostic circuit of the IC, (i) a plurality of test outputs that may include the test output of each of the plurality of cores and (ii) a default selection signal. The default selection signal may indicate one of the plurality of test outputs as a default test output. The diagnostic method may further comprise identifying, by the diagnostic circuit, based on the plurality of test outputs and the default test output, a defective set of cores of the plurality of cores. The diagnostic method may further comprise outputting, by the diagnostic circuit, a set of defective outputs associated with the defective set of cores as a set of failure logs.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the spirit and scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements. The term "coupled" may refer to at least one of direct or indirect coupling that may not necessarily be by way of mechanical or any physical means. Further, a system or method that "comprises", "has", or "includes" one or more elements possesses those one or more elements but is not limited to possessing only those one or more elements.

## Claims

1. An integrated circuit, IC, comprising:
a plurality of cores that are identical, wherein each core of the plurality of cores is configured to generate a respective test output based on a plurality of test patterns; and
a diagnostic circuit coupled to the plurality of cores, wherein the diagnostic circuit is configured to:
receive (i) a plurality of test outputs that include the test output of each of the plurality of cores and (ii) a default selection signal, wherein the default selection signal indicates one of the plurality of test outputs as a default test output;
identify, based on the plurality of test outputs and the default test output, a defective set of cores of the plurality of cores; and
output a set of defective outputs associated with the defective set of defective cores as a set of failure logs.

2. The IC of claim 1, wherein the plurality of test patterns are associated with testing of the plurality of cores.

3. The IC of claim 1 or 2, wherein the diagnostic circuit comprises a comparator circuit, and wherein the comparator circuit is configured to:
receive the plurality of test outputs and the default selection signal;
compare each of the plurality of test outputs with the default test output; and
generate a plurality of status bits based on the comparison, wherein the defective set of cores is identified based on the plurality of status bits.

4. The IC of claim 3, wherein the comparator circuit comprises a default multiplexer configured to:
receive (i) the plurality of test outputs and (ii) the default selection signal; and
output one of the plurality of test outputs as the default test output based on the default selection signal.

5. The IC of claim 4, wherein the comparator circuit further comprises a plurality of exclusive-OR, XOR, gates coupled to the default multiplexer, and wherein each XOR gate of the plurality of XOR gates is configured to:
receive (i) a corresponding test output of the plurality of test outputs and (ii) the default test output; and
output one of a plurality of XOR signals based on the corresponding test output and the default test output.

6. The IC of claim 5, wherein the comparator circuit further comprises a first plurality of AND gates, wherein each AND gate of the first plurality of AND gates is coupled to a corresponding XOR gate of the plurality of XOR gates, and wherein each AND gate of the first plurality of AND gates is configured to:
receive a corresponding XOR signal of the plurality of XOR signals and a first enable signal; and
output one of a first plurality of AND signals based on the corresponding XOR signal and the first enable signal.

7. The IC of claim 6, wherein the comparator circuit further comprises a plurality of memory circuits, wherein each memory circuit of the plurality of memory circuits is coupled to a corresponding AND gate of the first plurality of AND gates, and wherein each memory circuit of the plurality of memory circuits is configured to:
receive a corresponding AND signal of the first plurality of AND signals and a clock signal as inputs;
generate a corresponding status bit of the plurality of status bits based on the inputs; and
output the generated status bit.

8. The IC of any of claims 3 to 7, wherein the diagnostic circuit further comprises a selection circuit coupled to the comparator circuit, and wherein the selection circuit is configured to:
receive the plurality of status bits, the plurality of test outputs, the default test output, and a mode signal, wherein the identification of the defective set of cores is based on the plurality of status bits, and wherein the mode signal is generated based on the plurality of status bits; and
output one of
(i) in a set of iterations, the set of defective outputs and a set of core identifiers indicative of the defective set of cores when the mode signal indicates that the selection circuit operates in a normal mode,
wherein in each iteration of the set of iterations, a corresponding defective output of the set of defective outputs and a corresponding core identifier of the set of core identifiers is outputted, and
(ii) a defective output that corresponds to the default test output and a core identifier that is indicative of the core associated with the default test output when the mode signal indicates that the selection circuit operates in a default mode, wherein the set of defective outputs includes the default test output.

9. The IC of claim 8, further comprising a plurality of output pads coupled to the selection circuit, wherein the plurality of output pads comprises a first set of output pads and a second set of output pads, and wherein in each iteration of the set of iterations,
(i) the first set of output pads is configured to:
receive the corresponding defective output of the set of defective outputs; and
provide the corresponding defective output as a failure log of the set of failure logs, from the IC to a test system; and
(ii) the second set of output pads is configured to:
receive the corresponding core identifier associated with the corresponding defective output; and
provide the corresponding core identifier from the IC to the test system.

10. The IC of claim 8 or 9, wherein the selection circuit comprises a control circuit, and wherein when the selection circuit operates in the normal mode, the control circuit is configured to:
output,
(i) in a first iteration of the set of iterations, a plurality of logic signals associated with the plurality of cores based on the plurality of status bits, wherein each of the plurality of logic signals is de-asserted, and
(ii) in each remaining iteration of the set of iterations, the plurality of logic signals such that a logic signal associated with a core identifier of the set of core identifiers outputted in a preceding iteration of the set of iterations is asserted.

11. The IC of claim 10,
wherein each status bit of the plurality of status bits is associated with a core of the plurality of cores,
wherein a value of a status bit of the plurality of status bits being one indicates that the core associated with the corresponding status bit is defective, and
wherein the control circuit is further configured to provide, to a test system,
(i) in the first iteration, a core identifier of the set of core identifiers associated with a least significant bit of the plurality of status bits, wherein the least significant bit is asserted, and
(ii) in each remaining iteration of the set of iterations, a core identifier of the set of core identifiers associated with a status bit that (i) is asserted and (ii) succeeds the status bit associated with the core identifier outputted in the preceding iteration.

12. The IC of claim 11, wherein the selection circuit further comprises:
a plurality of inverters coupled to the control circuit, wherein the plurality of inverters is associated with the plurality of cores, and wherein when the selection circuit operates in the normal mode, each inverter of the plurality of inverters is configured to:
receive a logic signal of the plurality of logic signals;
invert the logic signal; and
output one of a plurality of inverted logic signals; and
a second plurality of AND gates coupled to the plurality of inverters, wherein the second plurality of AND gates are associated with the plurality of cores, and wherein each AND gate of the second plurality of AND gates is configured to:
receive a corresponding status bit of the plurality of status bits and a corresponding inverted logic signal of the plurality of inverted logic signals as inputs; and
output one of a second plurality of AND signals based on the corresponding status bit and the corresponding inverted logic signal.

13. The IC of claim 12, wherein the selection circuit further comprises a plurality of control multiplexers coupled to the second plurality of AND gates, wherein the plurality of control multiplexers is associated with the plurality of cores, and wherein when the selection circuit operates in the normal mode, each control multiplexer of the plurality of control multiplexers is configured to:
receive a corresponding AND signal of the second plurality of AND signals, a second enable signal, and a select signal; and
output one of a plurality of control signals based on the select signal.

14. The IC of claim 13,
wherein the selection circuit further comprises a plurality of expose multiplexers coupled to the plurality of control multiplexers and the plurality of cores,
wherein when the selection circuit operates in the normal mode, a default expose multiplexer of the plurality of expose multiplexers is configured to:
receive the default test output, a corresponding test output of the plurality of test outputs, and a corresponding control signal of the plurality of control signals; and
output one of the default test output and the corresponding test output as the set of failure logs based on the corresponding control signal,
wherein each remaining expose multiplexer of the plurality of expose multiplexers is coupled to a preceding expose multiplexer of the plurality of expose multiplexers,
wherein each remaining expose multiplexer of the plurality of expose multiplexers is configured to:
receive a corresponding test output of the plurality of test outputs, a corresponding control signal of the plurality of control signals, and an output of the preceding expose multiplexer; and
output one of the corresponding test output and the output of the preceding expose multiplexer based on the corresponding control signal, and
wherein a first expose multiplexer of the plurality of expose multiplexers, outputs in a corresponding iteration of the set of iterations, a corresponding defective output of the set of defective outputs.

15. A diagnostic method, comprising:
generating, by each core of a plurality of cores of an integrated circuit (IC), a respective test output based on a plurality of test patterns, wherein the plurality of cores are identical;
receiving, by a diagnostic circuit of the IC, (i) a plurality of test outputs that include the test output of each of the plurality of cores and (ii) a default selection signal, wherein the default selection signal indicates one of the plurality of test outputs as a default test output;
identifying, by the diagnostic circuit, based on the plurality of test outputs and the default test output, a defective set of cores of the plurality of cores; and
outputting, by the diagnostic circuit, a set of defective outputs associated with the defective set of cores as a set of failure logs.
